# EUROPEAN PATENT APPLICATION

(11) **EP 3 979 323 A1**
(43) Date of publication of application: **06.04.2022**
(21) Application number: 20813586.3
(22) Date of filing: 28.05.2020
(51) Int. Cl.: H01L 27/15, G02B 30/30

(54) **NAKED-EYE THREE-DIMENSIONAL DISPLAY DEVICE AND NAKED-EYE THREE-DIMENSIONAL DISPLAY UNIT**

(30) Priority: 29.05.2019 CN 201910461814
(71) Applicant: Beijing Ivisual 3D Technology Co., Ltd., Beijing 100055 (CN); Visiotech Ventures Pte. Ltd., Singapore 188979 (SG)
(72) Inventor: DIAO, Honghao, Beijing 100055 (CN); HUANG, Lingxi, Singapore 188979 (SG)
(74) Representative: Manitz Finsterwald Patent- und Rechtsanwaltspartnerschaft mbB
(86) International application number: PCT/CN2020/092860
(87) International publication number: WO 2020/239008

(57) **Abstract**

The present application relates to the field of display technologies, and discloses a naked eye stereoscopic display device, including an LED light emitting device packaging structure and a grating attached to the LED light emitting device packaging structure, where the LED light emitting device packaging structure includes a plurality of LED subpixels and a package for packaging the plurality of LED subpixels, where the plurality of LED subpixels are set as an LED subpixel array with a single row, a single column or multiple rows and multiple columns, and at least one of the plurality of LED subpixels includes a scanning end being capable to connect to a scanning line and a data signal end being capable to connect to a data line. The naked eye stereoscopic display device provided by the present application may avoid the sharp drop of resolution during multi-viewpoint 3D display as far as possible. The present application further discloses a naked eye stereoscopic display unit.

## Description

The present application claims the priority over the Chinese patent application, with the application No. 201910461814.8 and the invention name "Naked Eye Stereoscopic Display Device", submitted to China National Intellectual Property Administration on May 29, 2019, and its whole content is incorporated in the present application by reference.

### Technical Field

The present application relates to the field of display technologies, for example, a naked eye stereoscopic display device and a naked eye stereoscopic display unit.

### Background

At present, the traditional naked eye stereoscopic (3D) display may conduct 3D display, and the total resolution thereof is a fixed value.

At least the following problems are found in the related technologies during the process of implementing the embodiments of the present disclosure:
When conducting multi-viewpoint (e.g. N viewpoints) 3D display, the resolution of the traditional naked eye stereoscopic display drops sharply, for example, the column resolution drops to *1*/*N* of the original resolution.

An N-viewpoint naked eye 3D display device with high definition, such as N times that of the 2D display device, needs to be provided to maintain high-definition display. The display device of such specification is difficult for LCD or other display technologies to realize. For example, at the current ultra-high resolution, the LCD at 8K resolution has bottlenecks in writing time and lining delay. The multi-viewpoint 3D display with "actual" resolution of *N* times of that of 2D display is almost impossible to be realized by using LCD of current multi-viewpoint naked eye 3D display or other display technologies.

Thus, the industry has a demand for the naked eye 3D display technology, such as the multi-viewpoint naked eye 3D display device.

### Summary

For basic understanding of some aspects of the disclosed embodiments, a simple summary is given below. The summary is not a general comment, nor determines the key/important composition elements or describes the protection scope of the embodiments, but is a preface to the detailed description later.

Embodiments of the present disclosure provide a naked eye stereoscopic display device and a naked eye stereoscopic display unit to solve the technical problem that the resolution drops sharply when conducting multi-viewpoint 3D display.

The naked eye stereoscopic display device provided by embodiments of the present disclosure includes a light emitting diode (LED) light emitting device packaging structure and a grating attached to the LED light emitting device packaging structure, where the LED light emitting device packaging structure includes a plurality of LED subpixels and a package for packaging the plurality of LED subpixels, where the plurality of LED subpixels are set as an LED subpixel array with a single row, a single column or of multiple rows and multiple columns, and at least one of the plurality of LED subpixels includes a scanning end being capable to connect to a scanning line and a data signal end being capable to connect to a data line.

In some embodiments, at least one of the plurality of LED subpixels may be a micro LED subpixel.

In some embodiments, the LED light emitting device packaging structure may further include at least one driving IC unit being capable to connected to at least one device pin, where the scanning line and the data line may be connected to at least one driving IC unit.

In some embodiments, the grating may be a prism grating.

In some embodiments, the grating may be a column prism grating.

In some embodiments, the grating may be a spherical prism grating.

In some embodiments, a single row or a single column of LED subpixels in the plurality of LED subpixels may be monochromatic subpixels.

In some embodiments, the plurality of LED subpixels may be set as a multi-row and multi-column LED subpixel array, and the LED subpixel array may include a plurality of subpixel groups, and at least one of the plurality of subpixel groups may include a plurality of subpixels with different colors.

In some embodiments, the plurality of LED subpixels may be set as a multi-row and multi-column LED subpixel array, and the LED subpixel array may include a plurality of subpixels with a same color.

In some embodiments, the grating may be a column prism grating or a spherical prism grating.

In some embodiments, when the grating is a column prism grating, a plurality of subpixel groups may be arranged in a manner that there are multiple groups in one row or multiple groups in one column. Optionally, when the grating is a spherical prism grating, at least one of the plurality of subpixel groups may be arranged in multiple rows and multiple columns.

In some embodiments, a plurality of LED subpixels may be arranged on a monolithic substrate.

In some embodiments, the driving IC unit may be arranged on the monolithic substrate.

In some embodiments, the package may include a transparent packaging material covering a plurality of LED subpixels, and a packaging frame located at periphery of the package.

In some embodiments, the package may further include a welding part located at a back side of the package. Optionally, the welding part may be constructed as a device pin or electrically connected with the device pin.

In some embodiments, the naked eye stereoscopic display device may be constructed as a passive driving type, and at least one of the plurality of LED subpixels is constructed as a two-terminal device.

In some embodiments, the naked eye stereoscopic display device may be constructed as an active driving type, and at least one of the plurality of LED subpixels is constructed as a multi-terminal device.

In some embodiments, at least one of the plurality of LED subpixels may be constructed as a multi-terminal device with positive and negative electrodes, a data end and a driving end.

In some embodiments, the multi-terminal device may be connected to at least one of a transistor and a capacitor.

The naked eye stereoscopic display unit provided by embodiments of the present disclosure includes a substrate and a plurality of naked eye stereoscopic display devices mentioned above, where the plurality of naked eye stereoscopic display devices are attached to the substrate in a form of array.

The naked eye stereoscopic display device and naked eye stereoscopic display unit provided by embodiments of the present disclosure may achieve the following technical effects:
Avoiding the sharp drop of resolution during multi-viewpoint 3D display as far as possible.

The above general description and the description below are only exemplary and explanatory and are not used for limiting the present application.

### Brief Description of the Drawings

At least one embodiment is exemplarily illustrated by corresponding drawings. The exemplary description and drawings do not constitute any limitation to the embodiments. The elements with the same reference number labels in the drawings are shown as similar elements. The drawings do not constitute any proportional limitation. In the drawings:
Fig. 1 shows a light emitting device according to an embodiment of the present disclosure;
Fig. 2 shows a light emitting device according to another embodiment of the present disclosure;
Fig. 3 shows another schematic diagram of the light emitting device shown in Fig. 2;
Fig. 4 shows a display unit according to an embodiment of the present disclosure;
Fig. 5 shows the combination of a packaging structure of the light emitting device and the grating according to an embodiment of the present disclosure;
Fig. 6 shows the combination of a packaging structure of the light emitting device and the grating according to another embodiment of the present disclosure;
Fig. 7 shows a display according to an embodiment of the present disclosure;
Fig. 8 shows a light emitting device according to an embodiment of the present disclosure;
Fig. 9 shows a light emitting device according to another embodiment of the present disclosure;
Fig. 10 shows another schematic diagram of the light emitting device of the embodiment shown in Fig. 9;
Fig. 11 shows a plurality of subpixel groups applicable to naked eye 3D display according to an embodiment of the present disclosure;
Fig. 12A shows a display unit according to an embodiment of the present disclosure;
Fig. 12B shows a display unit according to another embodiment of the present disclosure;
Fig. 13 shows a light emitting device according to another embodiment of the present disclosure;
Fig. 14 shows a display according to an embodiment of the present disclosure;
Fig. 15 shows a packaging structure of the light emitting device and the grating according to an embodiment of the present disclosure;
Fig. 16 schematically shows a circuit including a micro driver chip and a micro LED array according to an embodiment of the present disclosure;
Fig. 17 schematically shows a drive circuit to micro LED subpixels according to an embodiment of the present disclosure;
Fig. 18 schematically shows a structure of a multi-viewpoint naked eye stereoscopic display system according to an embodiment of the present disclosure.

### Detailed Description of the Embodiments

In order to enable a more detailed understanding of the characteristics and technical content of the embodiments of the present disclosure, the implementation of the embodiments of the present disclosure is described in detail below in conjunction with the drawings. The attached drawings are for reference and explanation only and are not used for limiting the embodiments of the present disclosure. In the following technical description, for convenience of explanation, a plurality of details are adopted to provide a full understanding of the disclosed embodiments. However, without these details, at least one embodiment can still be implemented. In other cases, well-known structures and devices may be displayed in a simple way in order to simplify the drawings.

Embodiments of the present disclosure provide a naked eye stereoscopic display device and a naked eye stereoscopic display unit to solve the technical problem that the resolution drops sharply when conducting multi-viewpoint 3D display.

The naked eye stereoscopic display device provided by embodiments of the present disclosure includes an LED light emitting device packaging structure and a grating attached to the LED light emitting device packaging structure, where the LED light emitting device packaging structure includes a plurality of LED subpixels and a package for packaging the plurality of LED subpixels, where the plurality of LED subpixels are set as an LED subpixel array with a single row, a single column or multiple rows and multiple columns, and at least one of the plurality of LED subpixels includes a scanning end being capable to connect to a scanning line and a data signal end being capable to connect to a data line.

In some embodiments, the scanning line and data line may be configured to be capable to directly or indirectly connect to at least one device pin.

In some embodiments, at least one of the plurality of LED subpixels may be a micro LED subpixel.

In some embodiments, the LED light emitting device packaging structure may further include at least one driving IC unit being capable to connect to at least one device pin, where the scanning line and the data line may be connected to at least one driving IC unit.

In some embodiments, the grating may be a prism grating.

In some embodiments, the grating may be a column prism grating.

In some embodiments, the grating may be a spherical prism grating.

In some embodiments, a single row or a single column of LED subpixels in the plurality of LED subpixels may be monochromatic subpixels.

In some embodiments, the plurality of LED subpixels may be set as a multi-row and multi-column LED subpixel array, the LED subpixel array may include a plurality of subpixel groups, and at least one of the plurality of subpixel groups may include a plurality of subpixels with different colors.

In some embodiments, the plurality of LED subpixels may be set as a multi-row and multi-column LED subpixel array, and the LED subpixel array may include a plurality of subpixels with a same color.

In some embodiments, the grating may be a column prism grating or a spherical prism grating. In some embodiments, when the grating is a column prism grating, a plurality of subpixel groups may be arranged in a manner that there are multiple groups in one row or multiple groups in one column. Optionally, when the grating is a spherical prism grating, at least one of the plurality of subpixel groups may be arranged in multiple rows and multiple columns.

In some embodiments, a plurality of LED subpixels may be arranged on a monolithic substrate.

In some embodiments, the driving IC unit may be arranged on the monolithic substrate.

In some embodiments, the package may include a transparent packaging material covering a plurality of LED subpixels, and a packaging frame located at periphery of the package.

In some embodiments, the package may further include a welding part located at a back side of the package. Optionally, the welding part may be constructed as a device pin or electrically connected with the device pin.

In some embodiments, the naked eye stereoscopic display device may be located as a passive driving type, and at least one of the plurality of LED subpixels is constructed as a two-terminal device.

In some embodiments, the naked eye stereoscopic display device may be constructed as an active driving type, and at least one of the plurality of LED subpixels is constructed as a multi-terminal device.

In some embodiments, at least one of the plurality of LED subpixels may be constructed as a multi-terminal device with positive and negative electrodes, a data end and a driving end.

In some embodiments, the multi-terminal device may be connected to at least one of a transistor and a capacitor.

The naked eye stereoscopic display unit provided by embodiments of the present disclosure includes a substrate and a plurality of naked eye stereoscopic display devices above, where the plurality of naked eye stereoscopic display devices are attached to the substrate in a form of array.

Embodiments of the present disclosure further provide a composite pixel packaging structure, a naked eye stereoscopic display unit and a naked eye stereoscopic display to solve the technical problem that the resolution drops sharply when conducting multi-viewpoint 3D display.

The composite pixel packaging structure provided by embodiments of the present disclosure includes an LED light emitting device packaging structure and a grating attached to the LED light emitting device packaging structure, where the LED light emitting device packaging structure includes a plurality of subpixel groups and a package for packaging a plurality of subpixel groups, at least one of the subpixel groups includes a plurality of subpixels with different colors, the plurality of subpixel groups are arranged in a manner that there are multiple groups in one row, multiple groups in one column, or in multiple rows and columns, so as to define at least one pixel for multi-viewpoint naked eye stereoscopic display.

In some embodiments, the grating may be a prism grating.

In some embodiments, the grating may be a column prism grating.

In some embodiments, a plurality of subpixel groups may be arranged in a manner that there are multiple groups in one row or multiple groups in one column.

In some embodiments, the grating may be a spherical prism grating.

In some embodiments, a plurality of subpixel groups may be arranged in multiple rows and multiple columns.

The composite pixel packaging structure provided by embodiments of the present disclosure includes an LED light emitting device packaging structure and a grating attached to the LED light emitting device packaging structure, where the LED light emitting device packaging structure includes a plurality of subpixels and a package for packaging the plurality of subpixels. The plurality of subpixels include a plurality of subpixels with a same color, which are arranged in a form of subpixel array of one row and multiple columns, one column and multiple rows or multiple rows and multiple columns, so as to define at least one subpixel for multi-viewpoint naked eye stereoscopic display.

In some embodiments, the grating may be a prism grating.

In some embodiments, the grating may be a spherical prism grating.

The naked eye stereoscopic display unit provided by embodiments of the present disclosure include a substrate and a plurality of the above composite pixel packaging structures.

The plurality of composite pixel packaging structures include a first composite pixel packaging structure, a second composite pixel packaging structure and a third composite pixel packaging structure, where subpixels in a first color are packaged in the first composite pixel packaging structure, subpixels in a second color are packaged in the second composite pixel packaging structure, and subpixels in a third color are packaged in the third composite pixel packaging structure.

In some embodiments, the naked eye stereoscopic display unit may further include a fourth composite pixel packaging structure in which subpixels in a fourth color are packaged.

In some embodiments, the plurality of composite pixel packaging structures above may further include subpixels in other colors other than the subpixels in the first color to the third color, such as at least one of subpixels in a fifth color, subpixels in a sixth color, subpixels in a seventh color, etc.

In some embodiments, the naked eye stereoscopic display unit may be constructed as a separate display, and the display includes a driving controller and a display housing.

The naked eye stereoscopic display provided by embodiments of the present disclosure include a plurality of the above naked eye stereoscopic display units, where the plurality of naked eye stereoscopic display units are arranged in a form of array.

In some embodiments, the naked eye stereoscopic display may be a high-definition display or an ultra-high-definition display.

In some embodiments, the naked eye stereoscopic display may be an indoor display or an outdoor display.

In some embodiments, the naked eye stereoscopic display may further include a supporting frame.

Herein, "pixel" means the display unit of the display in terms of its resolution. Herein, "subpixel", for example, refers to a display unit that presents a single color in a pixel. Thus, a single pixel may include a set of subpixels, such as RGB (red-green-blue), RGBW (red-green-blue-white), RYYB (red-yellow-yellow-blue), or RGBYC (red-green-blue-yellow-cyan). However, the pixels defined herein do not mean that the subpixels must be arranged adjacent to each other, for example, other components, such as other subpixels, may be set between subpixels of the same "pixel".

In some embodiments herein, when applied to the multi-viewpoint technology in the field of naked eye stereoscopic display, the "pixel" referred to, such as "composite pixel", refers to the display unit when the naked eye stereoscopic display provides multi-viewpoint display, but a single pixel in the multi-viewpoint display may include or present as a plurality of 2D display pixels. Sometimes, "3D display" or "multi-viewpoint" pixels may also called a pixel group. Herein, "composite pixel" means a 3D display pixel that provides a plurality of viewpoints (e.g. at least 12 viewpoints). Similarly, when described as multi-viewpoint naked eye 3D display "subpixel" or sometimes referred to as a subpixel group, or referred to as a "composite subpixel", it may refer to a single color presented in the pixel when the naked eye stereoscopic display provides multi-viewpoint display.

"Monolithic integration" or its derivatives herein refer to the direct formation of at least LED (sub) pixels and corresponding electronic devices, such as transistors and optionally other functional components of display devices, such as capacitors and/or driving ICs on a common substrate, rather than the transfer to the substrate after forming pixels and electronic devices or the main structures respectively.

" Driving IC" herein refers to a drive integrated circuit capable of driving LED display devices, such as a plurality of LED (sub) pixels or pixel arrays, sometimes referred to as a drive chip, which may include a scan driver and a data driver.

"Driving controller" herein may also be referred to as the "emission controller", which controls or communicates with the driving IC, such as the scan driver and the data driver, in order to control the display of (sub) pixels. In embodiments of the present disclosure, the driving IC (such as the scan driver and the data driver) may be or not be a component of the driving controller.

"Display device" herein has a conventional meaning in the field and may be configured as a display, a display unit and a display module, including but not limited to a display that may be formed separately or spliced. In some embodiments, the display device or (separate or spliced) display may be connected to and communicates with at least one driving controller so as to provide a display system that may receive signals for display.

In embodiments of the present disclosure, a pixel unit (subpixel group) packaging structure with a grating, such as a composite pixel packaging structure, applicable to naked eye stereoscopic (3D) display, such as multi-viewpoint (e.g. at least 4 viewpoints, or at least 20 viewpoints, or 60 viewpoints) and/or naked eye stereoscopic (3D) display with high resolution (e.g. high definition (HD), 2K, 4K or 8K resolution), and a display device, a display unit, a display or a display system with such a packaging structure, are provided.

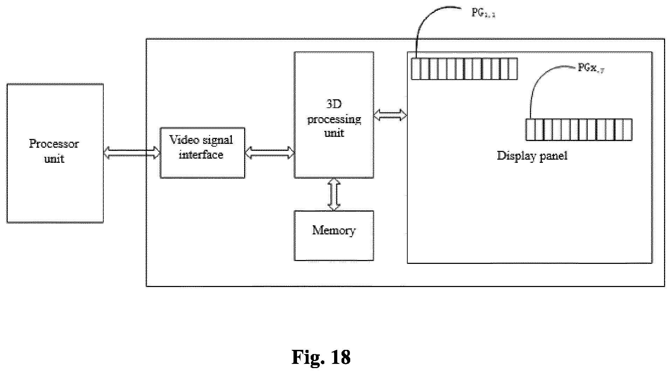

Fig. 18 shows a naked eye stereoscopic display system according to an embodiment of the present disclosure, which may include a processor unit and a multi-viewpoint naked eye stereoscopic display, where the processor unit is connected to and communicates with the multi-viewpoint naked eye stereoscopic display. In some embodiments herein, the processor unit includes a processing/transmitting/forwarding/control device capable of transmitting 3D video signals to the naked eye stereoscopic display, which may be a device with the function of generating and transmitting the 3D video signals at the same time, or a device that processes or does not process and forwards the received 3D video signals to the display. In some embodiments, the processor unit may be included in or referred to as the processing terminal or terminal.

The multi-viewpoint naked eye stereoscopic display may include a display panel or a display unit according to embodiments of the present disclosure, a video signal interface capable of receiving the 3D video signals, and a driving controller, such as a 3D video processing unit. In the embodiment, the display may have 12 viewpoints (not identified), or fewer or more viewpoints, for example, at least 20 viewpoints or 60 viewpoints.

In some embodiments, the display may further optionally include a memory to store the required data.

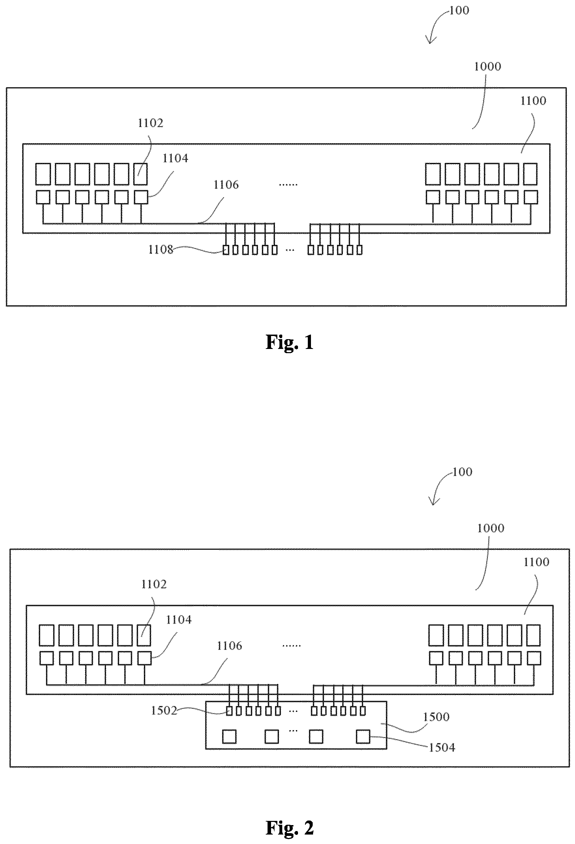

The display may include a plurality of rows and columns of pixels and defines a plurality of pixel groups, that is, a plurality of multi-viewpoints or naked eye stereoscopic display pixels. In the embodiment, for the purpose of illustration, only two schematic pixel groups PG1,1 and PGx, y are shown. Each pixel group corresponds to multi-viewpoint setting and has its own 12 pixels (P1-P12), which together define a single multi-viewpoint pixel. As a schematic embodiment, the pixels in the pixel group in Fig. 1 are arranged in a single row and multiple columns, or in any other form, such as single column and multiple rows or multiple rows and multiple columns. As schematic description only, the above PGx,y may be schematically represented in the pixel group in row X and column Y.

In some embodiments, a packaging display device capable of defining a single pixel group or a plurality of pixel groups or some subpixels in the pixel group is provided. For example, in some embodiments, the naked eye stereoscopic display device may include an LED light emitting device packaging structure and a grating attached to the LED light emitting device packaging structure, where the LED light emitting device packaging structure may include a plurality of LED subpixels and a package for the LED subpixels. The LED subpixel is, for example, a micro LED subpixel. The plurality of subpixels may form a subpixel array of single row and multiple columns, multiple rows and single column or multiple rows and multiple columns. The LED subpixel (array) of a single display device or a plurality of display devices may be connected to the respective (micro) driver chip, that is, the driving IC unit, which may also be packaged in the packaging structure of the display device. Such configuration in which a single or a plurality of display devices are equipped with the driving IC unit has special advantages over the driving IC configuration for the entire display (display panel), which is described below. The display devices may be spliced into a naked eye 3D display or display panel, and then a naked eye stereoscopic display system, as described below.

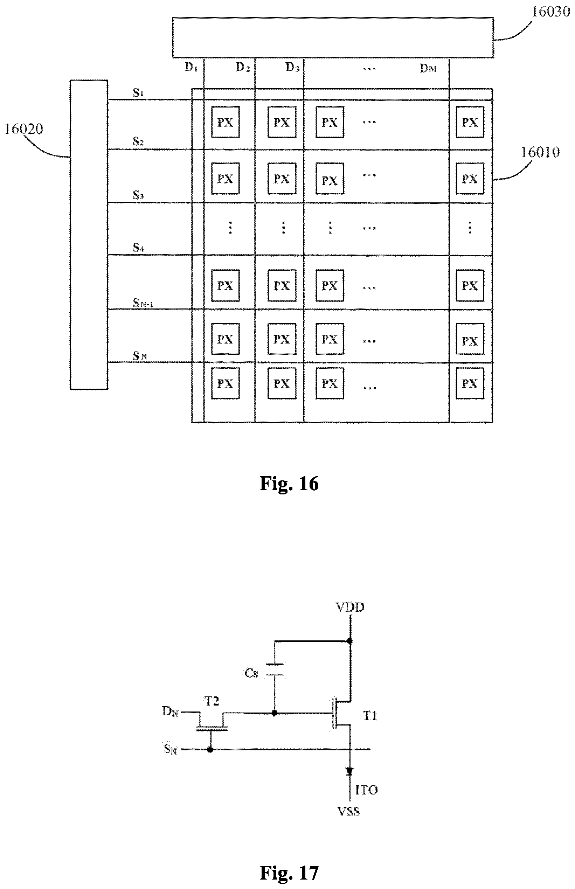

With reference to Fig. 16 and Fig. 17, Fig. 16 is the schematic diagram of the LED array of (a single or a plurality of) display devices and its (micro) driver chip, such as the active driving of the micro LED array, according to an embodiment of the present disclosure. Fig. 17 is the drive circuit diagram of the single LED subpixel and the micro LED subpixel 10 according to an embodiment of the present disclosure.

As shown in Fig. 16, each micro LED subpixel 16010 (e.g. the micro LED subpixel array) is connected to the scanning lines S1-SN and the data lines D1-DM with the scanning end and data signal end by means of the active driving circuit. The scanning lines S1-SN are connected to the scan driver 16020 in turn, and the data lines D1-DM are connected to the data driver 16030 in turn. The scan driver 16020 and the data driver 16030 may be communicatively connected to the transmission controller (not shown) of the display or display system, which may also be referred to as a driving controller.

In some embodiments, the transmission controller may receive the content to be displayed on the display device as input, for example, an input signal (e.g. a data frame) corresponding to image information. The purpose is achieved by optionally making the micro LED to emit light such as visible light. In some embodiments, the transmission controller may receive a data signal (e.g. a signal for turning the micro LED off or on). The scan driver and/or data driver may be part of or connected to the transmission controller. In the embodiment, the scan driver, for example, may allow and control the row communication between the transmission controller and micro LED (sub) pixels or the electronic device. The data driver may allow and control the column communication between the transmission controller and micro LED (sub) pixels or the electronic device.

Fig. 17 shows a schematic active driving circuit (corresponding electronic device) of the micro LED display (sub) pixel. In the embodiment, the micro LED (sub) pixel is connected in series with the first transistor T1 which may be the (first) high electron mobility transistor (HEMT) connected to an optional capacitor in the embodiment, and both ends of the line are connected to VDD (working voltage of electronic device) and VSS (common grounding terminal voltage) respectively. Optionally, a second transistor T2 is provided, which may be a (first) HEMT in the embodiment. The electrodes at both ends of the second transistor T2 are respectively connected to the data line and the gate of the first transistor T1, and the scanning line is connected to the gate of the second transistor T2.

As an exemplary explanation rather than limitation, the micro LED (sub) pixel is a current device. In the drive circuit of the subpixel, a capacitor is optionally provided to temporarily store the voltage, and the first transistor T1 which may be HEMT in the embodiment may be provided to convert the stored voltage into current. Thus, the transistor which is the HEMT herein converts the voltage applied to the gate into the current flowing through, and the transistor T1 which is the HEMT herein and the LED device are in a series connection structure, that is, the transistor T1 current is the current when the micro LED (sub) pixel works. Herein, the gate voltage of transistor T1 may be optionally the data voltage from the data line. As an exemplary explanation rather than limitation, a second transistor T2 which is HEMT herein may be further provided to selectively connect the data signal to the gate of the transistor T1, so that when the corresponding scanning line is an ON signal, the data signal may enter the gate of the transistor T1. When the corresponding scanning line is an OFF signal, due to the presence of the transistor T2, the data signal on the data line is independent of the gate voltage of the transistor T1, and the gate voltage is maintained by the capacitor Cs.

For example without limitation, more or fewer transistors may be provided for each subpixel, or as an alternative to HEMT, other monolithic integrated layered electronic devices may be used, such as other group III-V electronic devices, including but not limited to heterojunction bipolar transistor (HBT) and metal semiconductor FET (MESFET) or other GaN based electronic devices.

Although Fig. 16 and Fig. 17 show a schematic active driving inorganic LED display and its drive, which may have other drive forms and drive circuit devices.

In embodiments shown in Fig. 16 and Fig. 17, the display device is configured as active driving type, so that the LED subpixel 16010 is a multi-terminal device. The embodiments as shown, for example, include positive and negative electrodes, a data end and a driving end, which are connected to electronic devices such as the transistors, HEMT devices and/or capacitors. The display device may be further configured as a passive driving type, so that the LED subpixel is a two-terminal device, that is, connected to the positive electrode and negative electrode.

Fig. 1 shows a naked eye stereoscopic display device 100 according to an embodiment of the present disclosure, which may also be referred to as a (sub) pixel packaging unit with a grating, for example, a composite subpixel in case of the subpixels corresponding to more viewpoints. The naked eye stereoscopic display device 100 includes a plurality of light emitting devices in the form of LED subpixels which are micro LED subpixels herein. Optionally, the naked eye stereoscopic display device 100 in the embodiment includes an LED light emitting device packaging structure 1000 and a grating (not identified) attached to the LED light emitting device packaging structure. The grating is, for example, a prism grating or a column prism grating. The grating may be a prism grating in the embodiment herein. The packaging structure 1000 may include a light emitting device ((micro) LED) chip 1100. A plurality of (micro) LED subpixels 1102 are integrated on the micro LED chip 1100, which are the micro LED subpixels in one row and multiple columns. In the embodiment herein, the LED subpixels of the row are monochromatic subpixels. In the embodiment, the display device 100 further includes a packaging chip 1100 and further a package of the plurality of LED subpixels 1102.

In the embodiment shown in Fig. 1, each micro LED subpixel 1102 may include a scanning end connected to the scanning line and a data signal end connected to the data line. Herein, the scanning end and/or the data signal end may be in the form of a lead-out terminal (bonding bumper) 1104, and the scanning line and/or data line may be in the type of circuit wiring 1106.

In some embodiments, the scanning line and the data line are configured to be directly or indirectly connected in a combined manner to at least one device pin, for example in the form of a pad on the back side of the display device. As an exemplary example, the scan end and/or the data signal end in the form of lead-out terminal 1104 shown in Fig. 1 may be connected to the second lead-out terminal 1108 by means of the circuit wiring 1106, and the second lead-out terminal is connected to at least one device pin, for example, in a combined manner. In some embodiments, the driving IC unit of the display device may not be arranged in the packaging structure of the display device, but separately, for example, the driving IC unit provided independent of the packaging structure of the display device may include a data driver and a scan driver (or a row driver and a column driver) as shown in Fig. 17, and drives one or more corresponding display devices.

Fig. 2 shows a naked eye stereoscopic display device 100 according to an embodiment of the present disclosure, which may further include an LED light emitting device packaging structure 1000 and a grating (not identified) attached to the LED light emitting device packaging structure, where the packaging structure 1000 may include a light emitting device ((micro) LED) chip 1100. A plurality of (micro) LED subpixels 1102 are integrated on the micro LED chip 1100. The difference between the embodiment shown in Fig. 2 and the one shown in Fig. 1 is that the display device 100 of the embodiment of Fig. 2 (for example, the packaging structure) integrates a driving IC unit 1500 which drives the micro LED subpixel 1102 on the LED chip 1100. As shown in Fig. 2, the scanning end and/or data signal end in the form of lead-out terminal 1104 may be connected to the second lead-out terminal 1502 arranged in the driving IC unit 1500 by means of circuit wiring 1106. The driving IC unit 1500 may be provided with a small number of third lead-out terminals or device pin lead-out terminals 1504, for example, in the form of small pads.

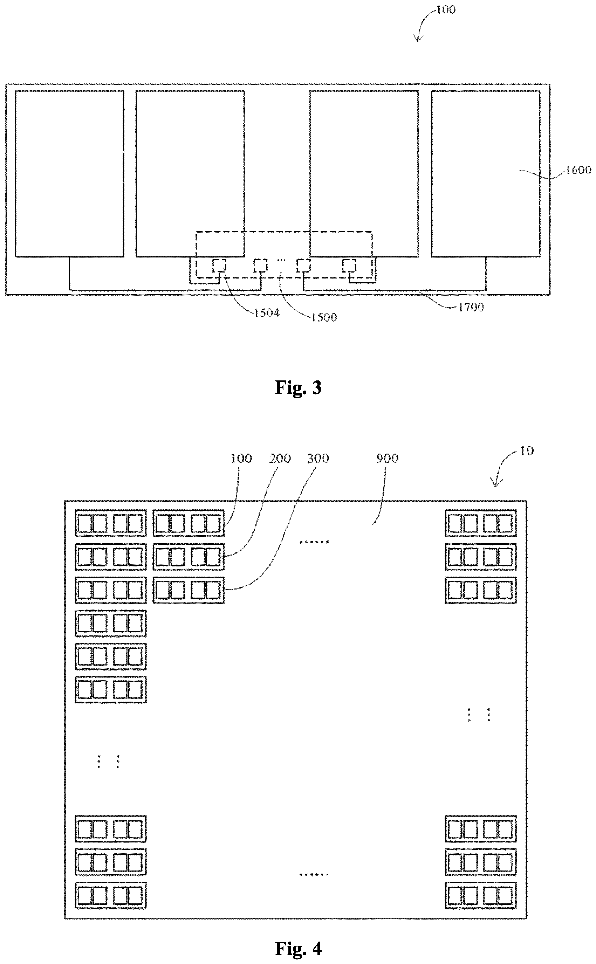

As shown in Fig. 3, the device pin lead-out terminal 1504 of the driving IC unit 1500 is connected to the device pin 1600, for example, by means of circuit wiring 1700, for example, in the form of a pad on the back side of the display device. In Fig. 3, the driving IC unit 1500 and its components are shown in dotted lines so as to indicate that they are packaged in the packaging structure.

In the embodiments shown in Fig. 2 and Fig. 3, the driving IC unit may include a data driver and a scan driver (or a row driver and a column driver) or both. For example, in an optional embodiment, only one driver is integrated in the packaging structure, and the other driver is, for example, externally arranged on the display device and drives a plurality of display devices. Further, some embodiments may include a configuration connected directly or indirectly (e. g., by the driving IC unit) to a device pin. For example, in some embodiments where only one driver is integrated in the packaging structure, the first lead-out terminal of the LED subpixel may be connected to the driving IC unit, and the circuit wiring connected to the second lead-out terminal may be directly connected to the pin so as to connect to the externally arranged driver.

Fig. 4 shows a display unit 10 applicable to naked eye 3D display according to an embodiment of the present disclosure. The display unit 10 may include a substrate 900 and a plurality of display devices 100, 200 and 300, which may be attached to the substrate in a form of array. In some embodiments, the display devices 100, 200 and 300 may be attached to the substrate 900 by means of Surface Mount Technology (SMT). In some embodiments, the substrate 900 may be provided with corresponding circuit wiring, and optionally, provided with a connected processor unit or transmission controller.

The display devices 200 and 300 may be the display devices shown in Figs. 1-3, but in different colors. As shown in Fig. 4, the display devices 100, 200 and 300 may be arranged in sequence along the column direction in the display unit 10. Thus, a group including one display device 100, one display device 200 and one display device 300 may constitute one pixel, that is, one pixel group of "multi-viewpoint" naked eye 3D display. Herein, the pixels in the pixel group are arranged in a single row and multiple columns, and the subpixels of the display devices 100, 200 and 300 each define the number of viewpoints. For example, if the number of corresponding "viewpoints" is high, that is, the display devices 100, 200 and 300 each have a large number of subpixels, the display devices 100, 200 and 300 each constitute a "composite subpixel" and together form a "composite pixel". With the help of such separately prepared display devices and a driving IC unit arranged or integrated in one or a plurality of display devices, the display or display unit adopting the technology disclosed herein is relatively easily prepared even if with the high resolution, such as 8K ^{∗} N (N is the number of viewpoints), 8K ^{∗} 60 or a small subpixel size, as well as supports the display, calculation and routing of such a high-resolution display.

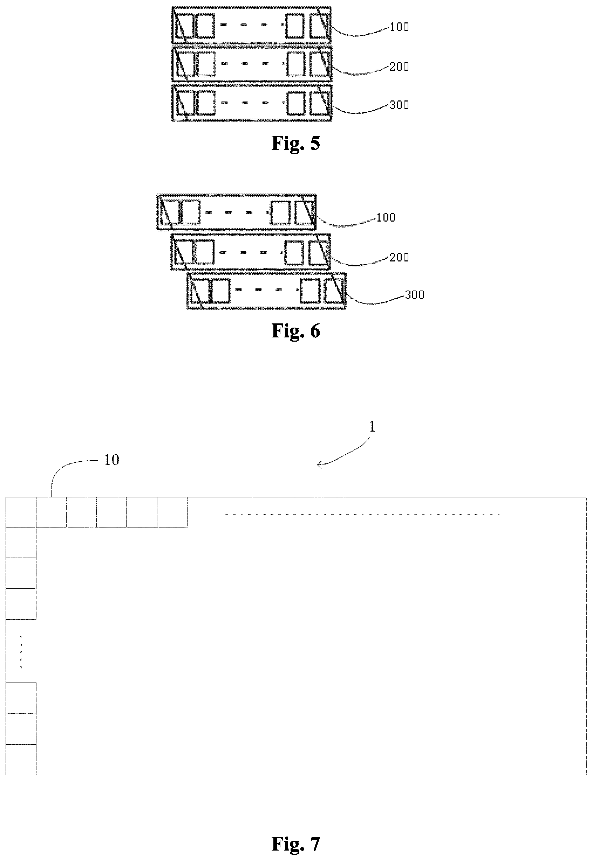

In the embodiment, the display devices 100, 200, 300 may be attached with a column prism respectively. In some embodiments, the column prism attached to the display device may be inclined relative to the vertical direction, as shown in Fig. 5. In some embodiments, another type of grating may be also combined.

In addition, the display devices 100, 200 and 300 may also be combined or arranged in another form, for example, in the form of vertical alignment as shown in Figs 4-5. Although the column prisms may be inclined as shown in Fig. 5, in some embodiments, the column prisms may be offset from each other as shown in Fig. 6, for example, to make the inclined column prisms aligned.

More display devices or display devices of different colors may be combined, for example, a group may include three or more display devices, defining RGB (red-green-blue), RGBW (red-green-blue-white), RYYB (red-yellow-yellow-blue), and RGBYC (red-green-blue-yellow-cyan). In some embodiments, more display devices may be combined, for example, to define other forms of "multi-viewpoint" naked eye 3D display. For example, a pixel group includes two or more display devices in the same row to realize higher multi-viewpoint display, or more rows of display devices, for example, to provide multi-viewpoint display of multiple rows and columns. In the latter case, the display device may be provided with a spherical lens (section).

In some embodiments, the embodiments shown in Figs. 1-3 may have alternative forms. For example, the LED light emitting devices or a plurality of (such as 3) LED chips on a plurality of different substrates are packaged and attached with gratings, so that the display device packaging the plurality of LED chips may present the functions of the group including the display devices 100, 200 and 300, that is, a pixel constituting a "multi-viewpoint" naked eye 3D display, that is, a pixel group, is formed. If the number of corresponding "viewpoints" is high, the display device packaging the plurality of LED chips may form a so-called "composite pixel" packaging structure.

In addition, with reference to Fig. 7, in some embodiments, a naked eye stereoscopic display device 1 or a display system may be provided, including a plurality of naked eye stereoscopic display units 10 which, for example, may be fixedly spliced into the entire display screen through a bracket, and optionally connected with an external drive signal, such as the processor unit shown in Fig. 18.

Thus, a naked eye 3D display with fairly high resolution may be provided, which may be a high-definition or ultra-high-definition display, such as a 2K, 4K or 8K display, and, for example, may be used as a super-large screen, high-definition indoor (e.g. cinema) or outdoor digital TV or smart TV.

In some embodiments, a single naked eye stereoscopic display unit may be configured as a separate display, which may include a driving controller and a display housing, for example, in some occasions where high resolution is not required.

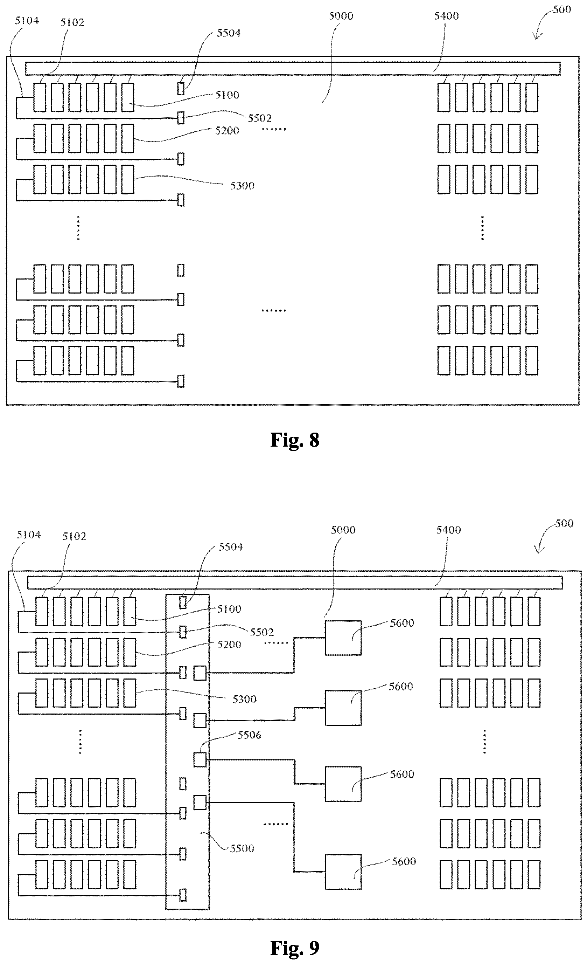

Fig. 8 shows a naked eye stereoscopic display device 500 according to another embodiment of the present disclosure, which may also be referred to as a (sub) pixel packaging unit with a grating. The naked eye stereoscopic display device 500 includes a plurality of light emitting devices in the form of LED subpixels which are micro LED subpixels herein. Optionally, in the embodiment, the naked eye stereoscopic display device 500 includes an LED light-emitting device packaging structure 5000 and a grating (not identified) attached to the LED light-emitting device packaging structure, such as a prism grating or a spherical grating. In the embodiment shown herein, the grating may be a prism grating. The packaging structure 5000 may include a light emitting device (micro) LED) chip. A plurality of (micro) LED subpixels 5100 forming a multi-row and multi-column micro LED subpixel array are integrated on the micro LED chip. In the embodiment, the display device 500 further includes a packaging chip, and then a package of the plurality of LED subpixels 5100.

In the embodiment shown in Fig. 8, each micro LED subpixel 5100 may include a scanning end connected to the scanning line and a data signal end connected to the data line. Herein, the scanning end and/or the data signal end may be in the form of the lead-out terminal 1104. The scanning line and/or data line may be in the form of circuit wiring 5102 and 5104.

As shown in Fig. 8, one of the scan end and/or data signal end in the form of lead-out terminal may be connected to the driving IC unit (driver) 5400 by means of circuit wiring 5102, and the other may be connected to the second lead-out terminal 5502 by means of circuit wiring 5104, and the second lead-out terminal may be, for example, connected to at least one device pin in a combined manner. The driving IC unit (driver) 5400 may be connected to the lead-out terminal 5504 of the driving IC unit, which may be connected to a device pin in turn. In some embodiments, another driving IC unit (driver) of the display device may not be arranged in the packaging structure of the display device, but separately. For example, the (integrated and separately arranged) driving IC unit of the display device of Fig. 8 may include a data drive and a scan drive (or a row drive and a column drive) as shown in Fig. 17, and drives one or a plurality of corresponding display devices.

A major difference between the embodiment shown in Fig. 8 and the ones shown in Figs. 1-3 is that a multi-row and multi-column micro LED subpixel array is packaged in the embodiment of Fig. 8, and the multi-row and multi-column micro LED subpixel array, for example, is arranged on a single chip, such as a monolithic integrated substrate. Herein, the micro LED subpixel array in the embodiment of Fig. 8, for example, may provide the function of a combination of a plurality of display devices in the embodiment of Fig. 4, as described below.

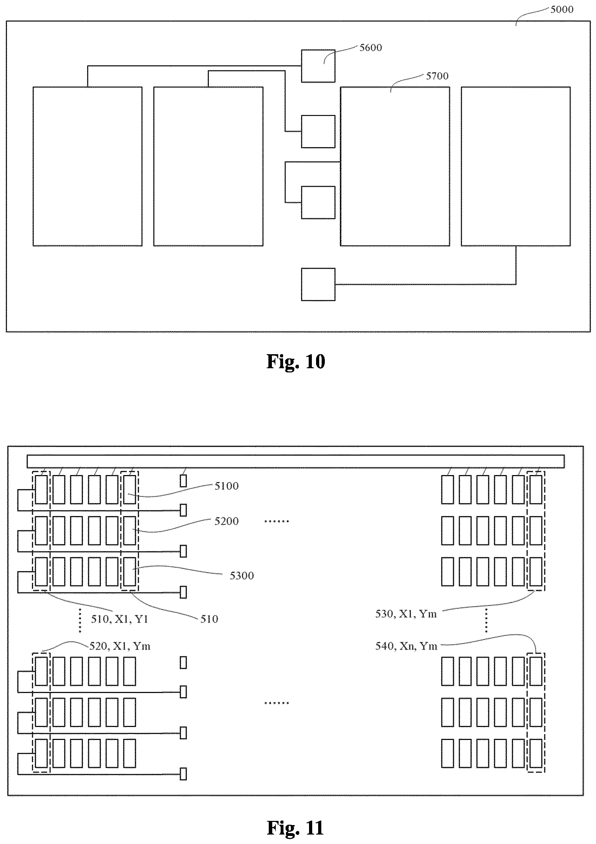

Fig. 9 shows a naked eye stereoscopic display device 500 according to another embodiment of the present disclosure, which is mainly different from the embodiment shown in Fig. 8 in that in addition to the (first) driving IC unit (driver) 5400, it further includes a (second) driving IC unit (driver) 5500 or the (second) driving IC unit (driver) 5500 is packaged in the embodiment. The other of one of the scan end and/or the data signal end may be connected to the second lead-out terminal 5502 on the (second) driving IC unit (driver) 5500 by means of circuit wiring 5104. The (second) driving IC unit (driver) 5500 may be further provided with a small number of third lead-out terminals 5506, which are connected to at least one lead-out pin 5700 (Fig. 10) arranged on the back side of the packaging structure, for example, in a form of small pad. In the embodiment, a pad 5600 is further provided to connect the third lead-out terminal 5506 to the lead-out pin 5700. In the embodiment, the driving IC unit lead-out terminal 5504 of the (first) driving IC unit (driver) 5400 may be arranged on the (second) driving IC unit (driver) 5500.

Referring to Figs. 8-11, as described above, the micro LED subpixel array, for example, may provide the functions of a combination of a plurality of display devices in the embodiment of Fig. 4. As shown in Fig. 11, for example, a plurality of (e.g. 3) micro LED subpixels 5100, 5200 and 5300 on the same column may form one pixel 510, 520, 530 and 540, or a plurality of LED subpixels on the same row may form one pixel. In addition, different subpixel combinations and numbers in the display device, such as 3 or more, may also be available to define RGB (red-green-blue), RGBW (red-green-blue-white), RYYB (red-yellow-yellow-blue) and RGBYC (red-green-blue-yellow-cyan).

Herein, a pixel group with multiple rows and columns (Xm, Yn) may be defined in the display device 500. In the embodiment, a spherical prism, for example, may be attached, so that *m*^{∗}*n* multi-row and multi-column viewpoints may be defined. Herein, if the number of viewpoints is high, a single display device 500 may form a composite pixel. In some embodiments, a column prism may be attached. Herein, for example, a plurality of (such as *n* ) pixels of multi-viewpoint naked eye 3D display may be defined, and each naked eye stereoscopic display pixel, for example, may have a plurality of (such as m) viewpoints.

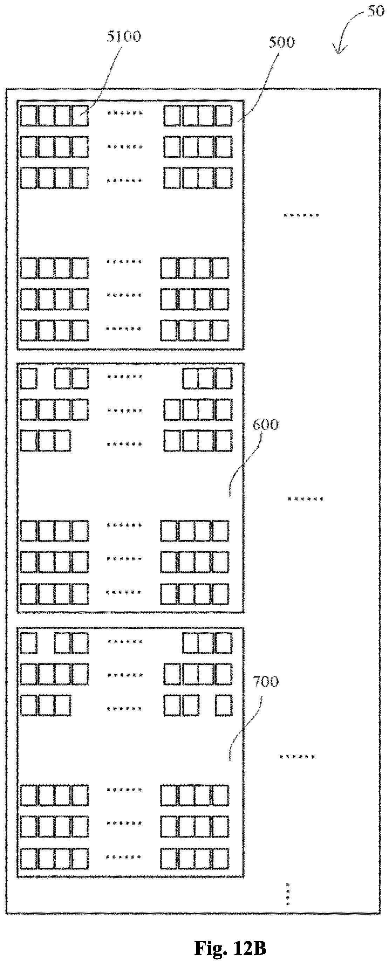

Referring to Figs. 8-10, an alternative embodiment is further provided. The micro LED subpixel array may include monochromatic micro LED subpixels. Similarly, a spherical prism may be attached to the display device 500. Herein, the multi-row and multi-column subpixels defined in the display device 500 may define a corresponding color in the corresponding number of multi-row and multi-column viewpoints, which may be referred to as the subpixel of multi-viewpoint naked eye stereoscopic display herein. If the number of viewpoints is high, a single display device 500 may form a composite subpixel (package). Herein, a plurality of monochromatic display devices 500 (with different colors from each other) may define a composite pixel together, as detailed in Fig. 12B below.

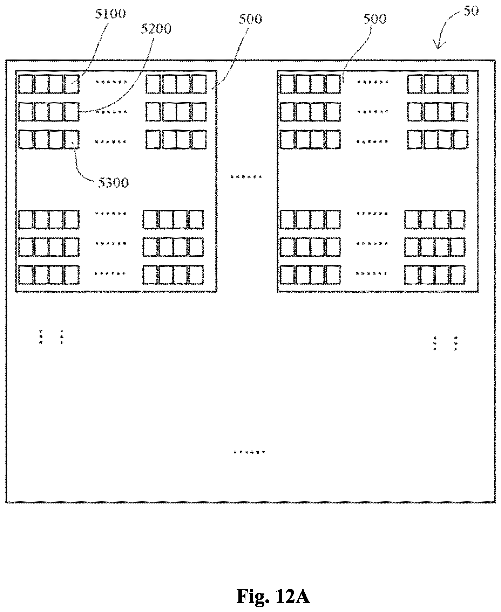

Fig. 12A shows a display unit 10 applicable to naked eye 3D display according to an embodiment of the present disclosure. The display unit 10 may include a substrate 900 and a plurality of display devices 500, 600 and 700, where the display devices 500, 600 and 700 may be the display devices in the embodiments shown in Figs. 8-11 and may have a variety of colors. As shown in Fig. 11, for example, a plurality of (e.g. 3) micro LED subpixels 5100, 5200 and 5300 on the same column may form one pixel together. The display device 500 may be attached to the substrate in a form of array. In some embodiments, the display device 500 may be attached to the substrate 900 by means of surface mount technology (SMT). Optionally, the display devices each form a "composite pixel".

Fig. 12B shows a display unit 10 applicable to naked eye 3D display according to an embodiment of the present disclosure. The display unit 10 may include a substrate 900 and a plurality of display devices 500, 600 and 700, where the display devices 500, 600 and 700 may be the display devices in the embodiments shown in Figs. 8-10, but the display devices 500, 600 and 700 includes monochromatic micro LED subpixels. For example, in one embodiment, the micro LED subpixel 5100 of the display device 500 may present a first color, such as red (R); the micro LED subpixel of the display device 600 may present a second color, such as green (g); and the micro LED subpixel of the display device 700 may present a third color, such as blue (B).

In some embodiments, a display, a display panel or a display unit with a new architecture is further provided, which includes a plurality of (such as 3, 4 or 5) subpixel arrays arranged in a form of array, which may jointly define a multi-viewpoint naked eye stereoscopic display pixel. Herein, the pixels in the embodiment of the display, display panel or display unit with the new architecture of the present disclosure break through the traditional structure, which defines a new pixel for naked eye 3D display. For the "pixel" in terms of 2D display, in the physical structure, the subpixels may be separated from each other, such as the subpixels in other 2D display pixels.

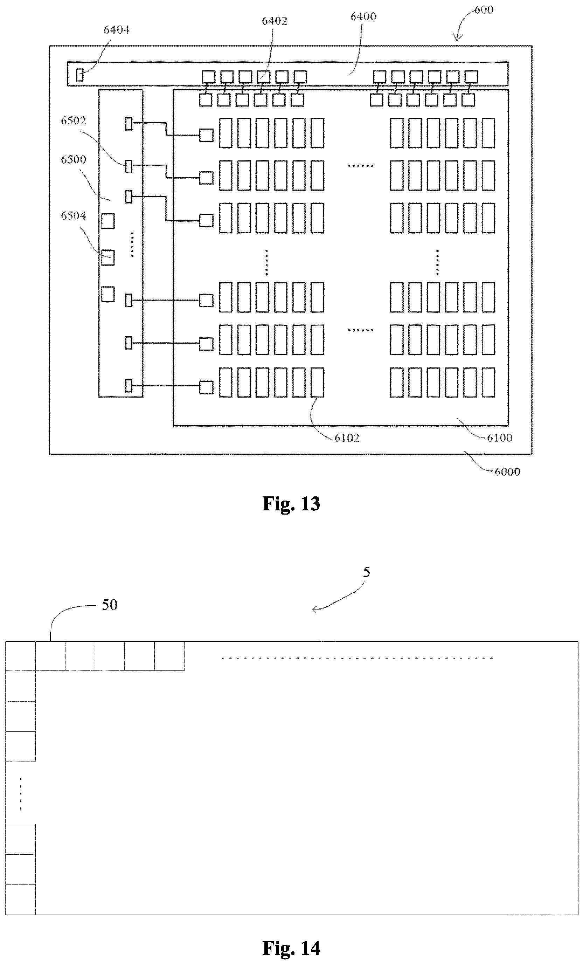

Fig. 13 shows a naked eye stereoscopic display device 600 according to another embodiment of the present disclosure, which is mainly different from the embodiment shown in Fig. 9 in that the (second) driving IC unit 6500 is arranged on the side and integrated on a separate chip or substrate, rather than vertically overlapping with the LED subpixel area or forming on the same chip or substrate as the (second) driving IC unit 5500.

In the embodiment shown in Fig. 13, the naked eye stereoscopic display device 600 includes a plurality of light emitting devices in the form of LED subpixels which are micro LED subpixels herein. Optionally, in the embodiment, the naked eye stereoscopic display device 500 includes an LED light emitting device packaging structure 5000 and a grating (not identified) attached to the LED light emitting device packaging structure, such as a prism grating or a spherical grating. In the embodiment shown herein, the grating may be a prism grating. The package structure 5000 may include a light emitting device ((micro) LED) chip 6100. Aplurality of (micro) LED subpixels 6102 are integrated on the micro LED chip, which are a multi-row and multi-column micro LED subpixel array. In the embodiment, the display device 600 further includes a packaging chip, and then a package of the plurality of LED subpixels 6100.

As shown in Fig. 13, one of the scan end and/or data signal end in the form of lead-out terminal may be connected to the (first) driving IC unit (driver) 6400 by means of circuit wiring, such as the pad 6402, and the other may be connected to the second lead-out terminal 6502 connected to the (second) driving IC unit (driver) 6500 by means of circuit wiring. The (second) driving IC unit (driver) 6500 may be further provided with a small number of third lead-out terminals 6504, for example, in a form of small pad. Similarly, the (first) driving IC unit (driver) 6400 may have its own pin lead-out terminal 6404,which, for example, is in a form of small pad. The lead-out terminals 6404 and 6504 may be connected to at least one lead-out pin arranged on the back side of the packaging structure.

In addition, with reference to Fig. 14, in some embodiments, a naked eye stereoscopic display device 5 or a display system may be provided, including a plurality of naked eye stereoscopic display units 50 which, for example, may be fixedly spliced into the entire display screen through a bracket, and optionally connected with an external drive signal, such as the processor unit shown in Fig. 18.

Thus, a naked eye 3D display with a super-large screen or fairly high resolution may be provided, which may be a high-definition or ultra-high-definition display, such as a 2K, 4K or 8K display, and for example, may be used as a super-large screen indoor or outdoor TV or cinema system.

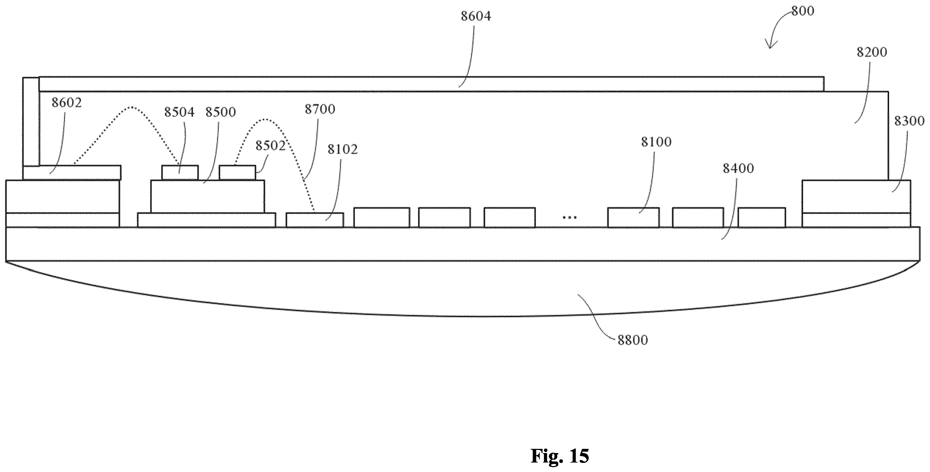

Fig. 15 shows a packaging structure diagram of a light emitting device and a grating according to an embodiment of the present disclosure. In the embodiment, the light emitting device and the driving IC unit may be monolithic integrated, for example, on a monolithic substrate material 8400, such as a sapphire substrate. Optionally, in the embodiment, the display device 800 includes a plurality of light emitting devices in the form of LED subpixels, which are micro LED subpixels 8100 herein. Optionally, in the embodiment, the display device 800 includes an LED light emitting device packaging structure and a grating attached to the LED light emitting device packaging structure, such as a prism grating 8800 or a column grating. The packaging structure may include a plurality of (micro) LED subpixels 8100 and a package for the plurality of LED subpixels 8100. Optionally, the packaging structure may include an packaging material 8200, such as a transparent packaging material or a resin packaging material, and an packaging frame 8300 arranged around the package. The packaging structure may further include an packaged driving IC unit 8500. The packaging structure may further include a plurality of pads and circuit wiring. For example, the packaging structure may include a pad 8102, for example, electrically connected with the LED subpixel 8100 through circuit wiring, and the driving IC unit 8500 may include a pad (or electrode) 8502 electrically connected with the pad 8102 through circuit wiring 8700 and a pad (or electrode) 8504 electrically connected with the welding part 8604 on the back side of the package. Optionally, the pad (or electrode) 8504 may be connected to the pad 8602 arranged on the frame by means of the circuit wiring 8700, which, for example, is connected to the welding part 8604 on the back side through the weldable part on the side.

In some embodiments described above, the packaged display device or packaging structure is provided with a grating. In some embodiments, a display device without a grating or a grating structure may be provided for different application fields.

In some embodiments, whether the prism (e.g. lens) includes a cylindrical prism, a spherical prism or has any other shape, at least one curve of the surface of the prism may be circular or non-circular macroscopically, such as oval, hyperbolic, parabolic, etc. Optionally, at least one curve of the surface of the prism may be in a non-circular shape microscopically, such as a polygon. Optionally, the shape of the prism may be determined according to the actual situation such as process requirements, for example, the shape of the surface of the prism.

The naked eye stereoscopic display device, composite pixel packaging structure, naked eye stereoscopic display unit and naked eye stereoscopic display provided by an embodiment of the present disclosure easily realize the micro LED display devices applied to naked eye 3D display in technology, and try to avoid the sharp drop of resolution during multi-viewpoint 3D display.

The display devices, displays and display systems illustrated in the above embodiments may be applied to or implemented by various possible entities, such as a TV or smart TV, personal computer, laptop, on-board human-computer interaction device, cellular phone, camera phone, smart phone, personal digital assistant, media player, navigation device, e-mail device, game console, tablet computer, wearable device, VR/AR device Internet of things system, smart home and industrial computer with the display function, such as the naked eye stereoscopic display function, or the combination of these devices.

The above description and figures fully illustrate the embodiments of the present disclosure so that those skilled in the art can practice them. Other embodiments may include structural, logical, electrical and process changes. The embodiments represent only possible changes. Unless explicitly required, individual components and functions are optional and the order of operation can be changed. Portions and features of some embodiments may be included in or replace portions and features of other embodiments. The scope of embodiments of the present disclosure includes the entire scope of the claims and all available equivalents of the claims. When used in this application, although the terms "first", "second" and the like may be used in this application to describe elements, these elements should not be limited by these terms. These terms are used only to distinguish one component from another, for example, without changing the meaning of the description, the first element may be called the second element, and similarly, the second element may be called the first element, as long as all the appearing "first elements" are renamed and all the appearing "second elements" are renamed. Both the first elements and the second elements are elements, but may not be the same elements. Moreover, the terms used in this application are only used for describing the embodiments but not used for limiting claims. As used in the description of the embodiments and claims, unless the context clearly indicates, "a", "an" and "the" in the singular form also include the plural form. Similarly, as used in this application, the term "and/or" refers to one or more listed associated possible combinations. In addition, when used in this application, the terms "comprise" and its variants "comprises" and/or "comprising" refer to the existence of stated features, whole, steps, operations, elements, and/or components, but do not exclude the existence or addition of one or more other features, whole, steps, operations, elements, and/or components. Without further restrictions, the element defined by the statement "comprises a..." does not exclude the existence of another same element in the process, method or equipment comprising the element. Herein, each embodiment can focus on the differences from other embodiments, and the same and similar parts between each embodiment can be referred to each other. For any method, product, etc. disclosed in the embodiments, if it corresponds to the method part disclosed in the embodiment, please refer to the description of the method part for relevant parts.

Those skilled in the art can understand that the units and algorithm steps of each example described in connection with the embodiments disclosed herein can be realized in electronic hardware or a combination of computer software and electronic hardware. Whether these functions are performed in hardware or software depends on the specific application and design constraints of the technical scheme. Those skilled in the art may use different methods for each specific application to realize the described functions, but such realization should not be considered to be beyond the scope of the embodiments of the present disclosure. Those skilled in the art can clearly understand that for the convenience and simplicity of description, the working processes of the above described systems, devices and units can refer to the corresponding processes in the above embodiment of methods, which are not repeated here.

In the embodiments disclosed herein, the disclosed methods and products (including but not limited to devices, equipment, etc.) can be realized in other ways. For example, the device embodiments described above are only schematic, for example, the division of units may only be a logical function division, and there may be another division mode in actual implementation; for example, a plurality of units or components may be combined or integrated into another system, or some features may be ignored or not executed. In addition, the mutual coupling or direct coupling or communication connection shown or discussed may be the indirect coupling or communication connection through some interfaces, devices or units, which may be electrical, mechanical or other forms. The unit described as a separate company may be or may not be physically separated, and the component displayed as a unit may be or may not be a physical unit, which may be arranged in one place or distributed in a plurality of network units. Some or all of the units may be selected according to actual needs to realize the present embodiment. In addition, the functional units in an embodiment of the present disclosure may be integrated in one processing unit, or exist separately and physically, or two or more units may be integrated in one unit.

In the drawings, for clarity and description, the width, length, thickness, etc. of the structures such as elements or layers may be exaggerated. When a structure such as an element or layer is referred to as "arranged" (or "installed", "laid", "bonded", "coated" and other similar descriptions) on or above another element or layer, the structure such as the element or layer may be directly set on or above another element or layer above or optionally set in the structure such as an intermediate element or layer between the other element or layer above, or even partially embedded in another element or layer above.

## Claims

1. A naked eye stereoscopic display device, comprising an light emitting diode LED light emitting device packaging structure and a grating attached to the LED light emitting device packaging structure, wherein the LED light emitting device packaging structure comprises a plurality of LED subpixels and a package for packaging the plurality of LED subpixels, wherein the plurality of LED subpixels are set as an LED subpixel array with a single row, a single column or multiple rows and multiple columns, and at least one of the plurality of LED subpixels includes a scanning end being capable to connect to a scanning line and a data signal end being capable to connect to a data line;
wherein, the scanning line and data line are configured to be capable to directly or indirectly connect to at least one device pin.

2. The naked eye stereoscopic display device according to claim 1, wherein at least one of the plurality of LED subpixels is a micro LED subpixel.

3. The naked eye stereoscopic display device according to claim 1, wherein the LED light emitting device packaging structure further comprises at least one driving IC unit being capable to connect to at least one device pin, wherein the scanning line and the data line are connected to the at least one driving IC unit.

4. The naked eye stereoscopic display device according to claim 1, wherein the grating is a prism grating.

5. The naked eye stereoscopic display device according to claim 4, wherein the grating is a column prism grating.

6. The naked eye stereoscopic display device according to claim 4, wherein the grating is a spherical prism grating.

7. The naked eye stereoscopic display device according to any of claims 1 to 6, wherein a single row or a single column of LED subpixels in the plurality of LED subpixels are monochromatic subpixels.

8. The naked eye stereoscopic display device according to any of claims 1 to 6, wherein the plurality of LED subpixels are set as a multi-row and multi-column LED subpixel array comprising a plurality of subpixel groups, and at least one of the plurality of subpixel groups includes a plurality of subpixels with different colors.

9. The naked eye stereoscopic display device according to any of claims 1 to 6, wherein the plurality of LED subpixels are set as a multi-row and multi-column LED subpixel array comprising a plurality of subpixels with a same color.

10. The naked eye stereoscopic display device according to claim 8, wherein the grating is a column prism grating or spherical prism grating.

11. The naked eye stereoscopic display device according to claim 10, wherein:
when the grating is a column prism grating, the plurality of subpixel groups are arranged in a manner that there are multiple groups in one row or multiple groups in one column, or
when the grating is a spherical prism grating, at least one of the plurality of subpixel groups is arranged in multiple rows and multiple columns.

12. The naked eye stereoscopic display device according to claim 1, wherein the plurality of LED subpixels are arranged on a monolithic substrate.

13. The naked eye stereoscopic display device according to claim 12, wherein the driving IC unit is arranged on the monolithic substrate.

14. The naked eye stereoscopic display device according to claim 1, wherein the package comprises:
a transparent packaging material covering the plurality of LED subpixels, and a packaging frame located at periphery of the package.

15. The naked eye stereoscopic display device according to claim 14, wherein the package further comprises:
a welding part located at a back side of the package;
wherein, the welding part is constructed as the device pin or electrically connected with the device pin.

16. The naked eye stereoscopic display device according to any of claims 1 to 15, wherein the naked eye stereoscopic display device is constructed as a passive driving type, and at least one of the plurality of LED subpixels is constructed as a two-terminal device.

17. The naked eye stereoscopic display device according to any of claims 1 to 15, wherein the naked eye stereoscopic display device is constructed as an active driving type, and at least one of the plurality of LED subpixels is constructed as a multi-terminal device.

18. The naked eye stereoscopic display device according to claim 17, wherein at least one of the plurality of LED subpixels is constructed as a multi-terminal device with positive and negative electrodes, a data end and a driving end.

19. The naked eye stereoscopic display device according to claim 17, wherein the multi-terminal device is connected to at least one of a transistor and a capacitor.

20. A naked eye stereoscopic display unit, comprising a substrate and a plurality of naked eye stereoscopic display devices according to any of claims 1 to 19, wherein the plurality of naked eye stereoscopic display devices are attached to the substrate in a form of array.
